(19) Europäisches Patentamt
European Patent Office
Office européen des brevets

(11) **EP 1 847 020 B1**

(12) **EUROPÄISCHE PATENTSCHRIFT**

(45) Veröffentlichungstag und Bekanntmachung des Hinweises auf die Patenterteilung:
**24.09.2008 Patentblatt 2008/39**

(51) Int Cl.:
*H03L 7/187* (2006.01)  *H03L 7/099* (2006.01)
*H03L 7/107* (2006.01)  *H03L 7/189* (2006.01)

(21) Anmeldenummer: **06706592.0**

(22) Anmeldetag: **02.02.2006**

(86) Internationale Anmeldenummer:
**PCT/EP2006/000922**

(87) Internationale Veröffentlichungsnummer:
**WO 2006/084627 (17.08.2006 Gazette 2006/33)**

(54) **PLL- SYNTHESIZER MIT VERBESSERTER VCO VORABSTIMMUNG**

PLL SYNTHESISER PROVIDED WITH AN IMPROVED VCO PRE-SETTING

SYNTHETISEUR PLL AVEC PRESYNTONISATION AMELIOREE DU VCO

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **11.02.2005 DE 102005006345**

(43) Veröffentlichungstag der Anmeldung:
**24.10.2007 Patentblatt 2007/43**

(73) Patentinhaber: **Rohde & Schwarz GmbH & Co. KG 81671 München (DE)**

(72) Erfinder: **SCHECHINGER, Alois 85283 Wolnzach (DE)**

(74) Vertreter: **Körfer, Thomas Mitscherlich & Partner Patent- und Rechtsanwälte Postfach 33 06 09 80066 München (DE)**

(56) Entgegenhaltungen:
**EP-A- 1 182 780      US-A- 4 205 272
US-B1- 6 552 617**

## Beschreibung

Die vorliegende Erfindung betrifft einen PLL (Phase Locked Loop = geschlossene Phasen-Regelschleife) -Synthesizer. Insbesondere betrifft die Erfindung eine Verbesserung einer PLL mit verbesserter VCO (**V**oltage **C**ontrolled Oscillator = spannungsgesteuerter Oszillator) Vorabstimmung.

PLL-Synthesizer werden in vielen Anwendungsbereichen eingesetzt. Beispiele finden sich im Mobilfunkbereich oder in der Mess- und Hochfrequenzmesstechnik. PLL-Synthesizer basieren auf einem Referenzoszillator oder Quarz, dessen Frequenz dann die Basis für ein vorbestimmtes Ausgangssignal liefert. Ein Phasendetektor vergleicht die vom Oszillator vorgegebene Referenzfrequenz mit der gewünschten Signalfrequenz und gibt entsprechende Spannungsimpulse aus. Diese werden dann in einer Integrator- oder Filterschaltung weiterverarbeitet und in einen spannungsgesteuerten Oszillator (VCO) eingespeist. Dieser paßt die Ausgangsschwingung entsprechend der Eingangsvorgabe in der Frequenz an, welche dann im Phasenkomparator oder -detektor wiederum in einer Feedbackschleife dem Phasendetektor zur Verfügung gestellt wird.

Basierend auf einer hochgenauen Referenzfrequenz können durch geeignete Teilungsfaktoren beliebige Frequenzen erzeugt werden. Dabei wird auf eine Phasen- bzw. Frequenzregelung zurückgegriffen, wobei als Regeldifferenz eine um den Faktor n skalierte Version der gewünschten Phasenfunktion mit der Schwingung des Oszillators verglichen wird. Ziele der Regelschleifenauslegung sind schnelle Frequenzwechselzeiten, geringes Signalrauschen, geringer Bauteileaufwand und kleine Einschwingzeiten.

Zur schnellen Frequenzselektion wird bei der DE 101 60 627 A1 eine Offsetspannung über eine Addier-Verstärkerschaltung nach einer ersten Filterstufe eingekoppelt. Nachteil dieser Methode ist jedoch, dass bei mehreren wählbaren Schleifenbandbreiten der schaltungstechnische Aufwand extrem groß wird.

Die Druckschrift US 4 205 272 A zeigt einen PLL-Synthesizer mit einem Phasendetektor, zumindest einem umschaltbaren Filter, einem durch eine Regelspannung geregelten Oszillator und einem Teiler wobei der geregelte Oszillator zwei Eingänge besitzt, wobei an einem ersten Eingang die Regelspannung und an einem zweiten Eingang eine Selektionsspannung zur groben Frequenzeinstellung eingekoppelt sind und wobei beide Spannungen die Frequenz des Oszillators festlegen, wobei der geregelte Oszillator zwei spannungsgesteuerte Varaktor-Dioden, eine Induktivität und zwei fest vorgegebene Kapazitäten aufweist, und wobei ein erster Widerstand mit einem zweiten Anschluss mit einem ersten Anschluss einer ersten Varaktor-Diode und ein zweiter Widerstand mit einem zweiten Anschluss mit einem ersten Anschluss einer zweiten Varaktor-Diode verbunden ist, und die Induktivität mit den Varaktor-Dioden eine Parallelschaltung bildet.

Damit ergibt sich als die Aufgabe der Erfindung, einen PLL-Synthesizer zu schaffen, bei dem möglichst zusätzliche Rauscheinträge verhindert sind und gleichzeitig der Schaltungsaufwand minimiert ist.

Die Aufgabe wird durch die Merkmale des Anspruchs 1 gelöst. Vorteilhafte Weiterbildungen sind in den Unteransprüchen angegeben.

Erfindungsgemäß werden weitere Filterstufen vermieden und nur passive Schaltungselemente verwendet. Weitere Filterstufen zur Rauschunterdrückung haben zusätzlich den Nachteil, direkt Einfluß auf die Schleifendynamik zu nehmen und laufen bei der Auslegung von PLL-Synthesizer den Zielen zur Optimierung der Schleifendynamik und Rauschunterdrückung entgegen. Ein Ziel der Lösung ist es, eine Frequenzselektionsspannung möglichst passiv und am besten direkt am VCO einzubringen. Damit lassen sich obengenannte Filterstufen vermeiden und die gemeinsame Behandlung der Hauptrauscheinflußfaktoren sowie der Regeldynamik wird mit nur einem Filter möglich.

Die vorliegende Erfindung realisiert eine Schaltung, die einen VCO mit zwei Eingängen nutzt. An den VCO kann dann an einen Anschluß eine Spannung $u_{SET}$ zur groben Frequenzselektion und an einen zweiten Eingang eine Regelspannung $u_{PLL}$ angelegt werden. Dabei kann die Spannung $u_{SET}$ zur groben Frequenzselektion bereits vorher gefiltert werden. An einem zweiten Eingang kann eine Restregelspannung $u_{PLL}$ eingespeist werden, die wie bisher von einem Phasendetektor, durch Vergleich von Eingangsspannung und der frequenzgeteilten Ausgangsspannung erzeugt wird und deren Spektraleigenschaften nur durch ein Filter festgelegt werden. Der zugehörige VCO besitzt somit zwei Eingänge. Statt die Spannungen $u_{SET}$ und $u_{PLL}$ an einer aktiven Schaltung zu addieren und dann nochmals zu filtern, wird mit dieser VCO-Realisierung die Spannung zur groben Frequenzselektion direkt am VCO passiv vorgegeben.

Damit ist es möglich einen bezüglich der Auslegung in der Schleifendynamik und im Rauschverhalten vereinfachten Regelkreis zu erhalten. Bei der bisherigen Regelkreisstruktur erforderte das Filterdesign die Auslegung zweier Filter. Bei dem erfindungsgemäßen PLL-Synthesizer wird das Design auf ein Filter beschränkt. Auf aktive Bauelemente wird dabei vollständig verzichtet. Das Filterdesign ist darauf ausgerichtet, die Rauscheinträge des Referenzoszillators und des Phasedetektors zu reduzieren und gleichzeitig eine geeignete Regeldynamik zur Verfügung zu stellen.

Durch die vorliegende Lösung kann eine rauschbehaftete Spannung zur groben Frequenzselektion $u_{SET}$ extrem gefiltert werden, ohne dass dadurch die Schleifendynamik beeinflußt wird. Die erforderliche Spannung Uset ist im Normalfall in einem elektronischen Speicher frequenzabhängig abgelegt und wird durch einen Digital-Analogwandler zur Verfügung gestellt. Die Steuerung des Schalters erfolgt für gewöhnlich digital, wobei die Schaltzeiten an die gewünschte Schleifenbandbreite angepasst sind. Die so vorgegebene Spannung $u_{SET}$ ist rauschbehaftet und muß gefiltert werden. Als bevorzugte Schaltung wird eine über einen Schalter vorladbare R-C-Tiefpassschaltung eingesetzt. Durch eine Vorladung der Kapazität der Tiefpassschaltung kann die Zeitkonstante überbrückt und das Filter sofort zur Filterung der Spannung $u_{SET}$ herangezogen werden. Damit wird zum einen die Spannung sofort in der vollen Amplitude bereitgestellt und so eine optimale Schaltespannung.

Zum anderen werden höherfrequente Rauschanteile die nicht vom Phasenregelkreis unterdrückt werden können, durch das schmalbandige Filter abgeblockt. Somit können schnelle Frequenzwechselzeiten erreicht werden, die Auslegung der Schleifendynamik vollkommen unabhängig von der Auslegung der Filterung gemacht werden und es kann gleichzeitig eine extrem schmalbandige Filterung der Spannung $u_{SET}$ vorgenommen werden.

Darüber hinaus sind auch weitere Verfahrensweisen zur Einkoppelung einer Biasspannung möglich. Außerdem kann eine zur Kapazität des R-C-Tiefpasses parallel zuschaltbar angebrachte Landekapazität verwendet werden, die die Ausgangsspannung zusätzlich glättet. Auch in diesem Falle können weitere Realisierungen eingesetzt werden, z.B. kann eine zweite Kapazität zeitversetzt parallel zuschaltbar ausgestaltet werden, so dass der Ladestrom eine maximale Amplitude nicht überschreitet.

Nachfolgend werden Ausführungsbeispiele der Erfindung unter Bezugnahme auf die Zeichnung beschrieben. In der Zeichnung zeigen:

Fig. 1    ein prinzipielles Blockschaltbild eines PLL-Synthesizers;

Fig. 2    die prinzipielle Arbeitsweise eines Phasendetektors;

Fig. 3    ein Blockschaltbild eines PLL-Synthesizers mit Vorabstimmung und wählbaren Bandbreiten nach Stand der Technik;

Fig. 4    ein Ausführungsbeispiel eines erfindungsgemäßen PLL-Synthesizers und

Fig. 5    ein Ausführungsbeispiel einer im Rahmen der Erfindung einsetzbaren VCO-Schaltung.

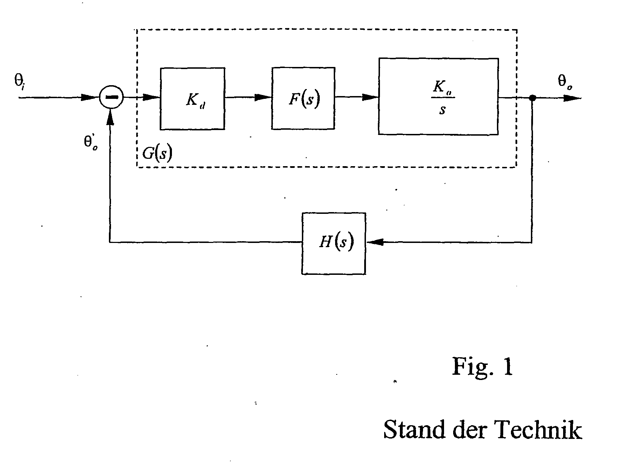

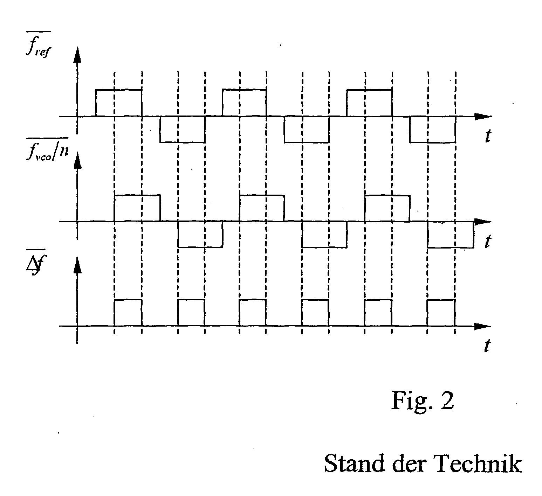

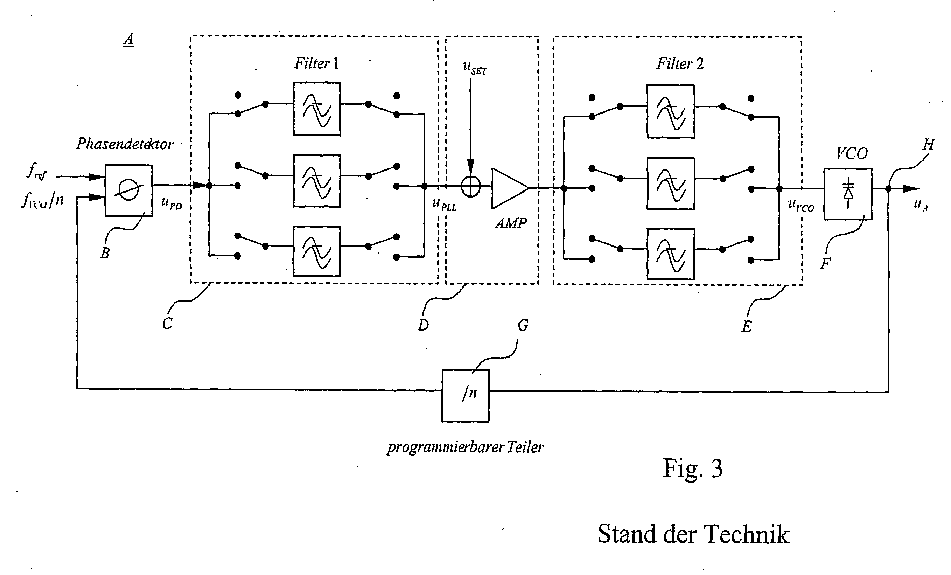

Bevor auf die erfindungsgemäße Lösung des Problems und damit auf die resultierende Schaltung eingegangen wird, werden nachfolgend, zum besseren Verständnis der Erfindung, einige Grundlagen zu PLL-Synthesizern bzw. -Regelkreisen anhand von Fig. 1 und 2 erläutert. Ein Ausführungsbeispiel der erfindungsgemäßen Schaltung wird dann unter Bezugnahme auf Fig. 3, 4 und 5 beschrieben.

Das Prinzip der Phase-Locked-Loop (im folgenden PLL) beruht auf einem Vergleich eines Referenzsignals mit einem Ist- oder Ausgangssignal. Das Referenzsignal wird dabei mit Hilfe eines hochgenauen Quarzes erzeugt. Mit einem programmierbaren Teiler ist es möglich, Signale mit einer Frequenz zu erzeugen, die in einem weiten Rahmen vorgegeben werden kann. Zum Vergleich der Signale werden sogenannte Phasendetektoren (im folgenden PD) oder Phasenkomparatoren eingesetzt.

Zunächst sei die Wirkungsweise eines PD linear modelliert. Diese Voraussetzung ist genau dann erfüllt, wenn die Schleife eingerastet ist. Darüber hinaus sei angenommen, dass die Ausgangsspannung des PD proportional zur Differenz der Phasen der Eingangssignale ist, d.h.

$$( 1 ) \qquad u_d = K_\theta \big(\theta_i - \theta_o\big) \qquad in \quad [V]$$

wobei $\theta_i$ und $\theta_o$ die Phasen der Referenzoszillatorschwingung bzw. des Ausgangssignals darstellen. $K_\theta$ ist dabei der Proportionalitätsfaktor des Phasendetektors und besitzt die Einheit [V/rad] bei Phasendetektoren mit Spannungsausgang bzw. [A/rad] bei Phasendetektoren mit Stromausgang. Auch der VCO wird als linear vorausgesetzt. Die Signalfrequenz an dessen Ausgang ergibt sich aus der Spannung am Filterausgang $u_e$ [V] und der Steigung der VCO Kennlinie $K_o$ [Hz/V]. Die Ausgangsfrequenz $\Delta\omega$ [rad/s] des VCO kann als:

$$( 2 ) \qquad \Delta\omega = K_o\, u_e(t) = \dot{\theta}_o(t) \quad \leftrightarrow \quad K_o\, U_e(s) = s \cdot \Theta_o(s).$$

angegeben werden. Der VCO trägt damit Tiefpasscharakter. Eine Laplacekorrespondenz wird durch '$\leftrightarrow$' notiert und korrespondierende Größen im Zeit- bzw. Frequenzbereich werden durch Klein- bzw. Großschreibung der entsprechenden Formelzeichen kenntlich gemacht, z.B. $u_e(t) \leftrightarrow U_e(s)$. Der Parameter s repräsentiert die zur Zeitvariable t korrespondierende bzw. duale Frequenzvariable mit Einheit $[s^{-1}]$.

Damit ergibt sich für die Übertragungsfunktion B(s) des geschlossenen Regelkreises:

$$( \ 3 \ ) \qquad B(s) = \frac{\theta_o(s)}{\theta_i(s)} = \frac{K_\theta K_o \ F(s)/s}{1 + K_\theta K_o \ F(s)/s}$$

wobei F(s) die Übertragungsfunktion eines möglichen Tiefpassfilters ist. In der einfachsten Konfiguration wird kein Tiefpassfilter eingesetzt und B(s) vereinfacht sich zu:

$$( \ 4 \ ) \qquad B(s) = \frac{\theta_o(s)}{\theta_i(s)} = \frac{K_\theta \cdot K_o}{s + K_\theta \cdot K_o} = \frac{1}{1 + ( \ s \ / \ W \ )}$$

was Tiefpasscharakteristik mit Verstärkung 1 und Bandbreite $W = K_\theta \cdot K_o$ repräsentiert.

Abweichend von obigem Model basiert ein PD auf dem Prinzip Eingangssignale (i.d.R. Sinusschwingungen) durch Thresholding in Rechtecksignale zu wandeln. Ein Phasenverzug stellt sich dann als Zeitverzug der Rechteckflanken dar. In der Differenz dieser gegeneinander verschobenen Eingangsrechtecksignale ergibt sich ein Differenzrechtecksignal, welches in Ladung umgesetzt in Pulsform die Regelspannung $u_{PLL}$ als Stellgröße vorgibt. Das in Gleichung ( 2 ) erhaltene Tiefpassverhalten für den VCO integriert die Spannungs- oder Ladungspulse und ergibt mit dem Verstärkungsfaktor $K_o$ die angesteuerte Phase $\theta_o$ des Ausgangssignals. Innerhalb des VCO kann man sich die Integration als Ableitung einer Treppenfunktion aus den Spannungspulsen vorstellen. Ergänzend veranschaulicht Fig. 1 die Differenzbildung der Eingangssignale im PD.

Ein VCO besteht aus einem L-C-Schwingkreis, in welchem z.B. in der gegebenen Erfindung Kapazitäten spannungsbasiert einstellbar angesteuert werden. Die Verwirklichung dieser ansteuerbaren Kapazitäten kann mit Kapazitäts- oder Varaktor-Dioden erfolgen. Damit gilt für die bekannte Formel für die Resonanzfrequenz $f_R$ des Schwingkreises:

$$( \ 5 \ ) \qquad f_R = \frac{1}{2\pi \cdot \sqrt{L \cdot C(u_s)}} \ \text{in} \quad [\text{Hz}]$$

wobei C(.) die Kennlinie der spannungsgesteuerten Kapazität ist und $u_s$ die Spannung zur Ansteuerung des Arbeitspunktes darstellt. Damit ergibt sich für die Ausgangsfrequenz des VCO zunächst:

$$( \ 6 \ ) \quad \Delta\omega_R = 2\pi f_R = \frac{1}{\sqrt{L \cdot C(u_s)}} = \frac{1}{\sqrt{L \cdot C(u_B + \delta u)}} \approx K_o \delta u \ \text{in} \ [\text{rad/s}]$$

Durch eine geeignete Linearisierung von ( 6 ) auf der Basis der Bauteilkennlinie C(.) um einen Arbeitspunkt C $(u_B)$ kann das VCO-Verhalten linear modelliert werden.

Im Folgenden wird der bisherige Stand der Technik beschrieben. Gemäß Fig. 3 besteht ein PLL-Synthesizer A aus einem PD (Phasendetektor) B, an dessen Eingängen eine Referenzfrequenz $f_{ref} = 1/(2\pi) \ \dot{\theta}_{ref}$, z. B. die eines nicht gezeigten Referenzoszillators und die, über einen programmierbaren Teiler G, in einer Feedbackschleife, rückgeleitete und um den Faktor n heruntergeteilte Frequenz $f_{vco}/n = 1/(2\pi) \ \dot{\theta}_{vco}/n$ anliegen. Am Ausgang des PD B ist ein erstes umschaltbares Filter C vorgesehen. In der Zeichnung sind für das Filter drei Möglichkeiten zur Bandbreitenselektion gezeigt. Über eine Addiererschaltung D wird zur Regelspannung $u_{PLL}$ eine Spannung zur groben Frequenzselektion $u_{SET}$ addiert. Die Gesamtspannung wird dann mit einen zweiten Filter E gefiltert und dem spannungsgesteuerten Oszillator F zugeführt. Die Ausgangsschwingung bzw. das Ausgangssignal wird dann, wie oben bereits angedeutet, über den Teiler G zum Phasendetektor B rückgekoppelt. Das Ausgangssignal kann am Ausgang H abgegriffen werden.

Die Regelspannung $u_{PLL}$ steht am Ausgang des ersten Filters C an. Dort wird dann eine Offset- oder Schaltspannung $u_{SET}$ zur Regelspannung $u_{PLL}$ addiert, so dass sich am Verstärker AMP eine Spannung $u_{PLL} + u_{SET}$ ergibt. Diese resultierende Spannung wird dann verstärkt und dann mittels eines umschaltbaren Filter E gefiltert, um das Rauschen, das der Spannung $u_{PLL} + u_{SET}$ überlagert ist, zu reduzieren. Das Rauschen hat seine Quelle sowohl von der Spannung $u_{SET}$, als auch im Verstärker AMP, der als Addierer arbeitet.

Die Übertragungsfunktion des Phasendetektors PD ist im Modell zweidimensional und zeitvariant angenommen. Das Übertragungsverhalten des PD kann zu einem gewissen Zeitpunkt und für eine gewisse Zeitdauer als linear modelliert werden, da wie in Fig. 2 zu sehen ist, die Aufgabe letztlich darin zu verstehen ist, zwei sinusförmige Eingangsspannungen durch geeignetes Thresholding, was durch Multiplikation mit einer geeigneten Funktion als lineare Operation dargestellt werden kann, zu modifizieren, um dann durch Subtraktion eine geeignete Ausgangsspannung zu erhalten, die geeignete Impulse an die Integratorschaltung $F_1(s)$ weiterleitet, welche die Spannungsimpulse in gegeneinander verschobene Sprungfunktionen umsetzt.

Wegen der schaltungs- und regelungstechnischen Vorteile erfolgt bei der erfindungsgemäßen Realisierung mit einem verbesserten spannungsgeregelten Oszillator (VCO) eine Einspeisung der Spannung $u_{SET}$ zur groben Frequenzselektion und der Regelspannung $u_{PLL}$ direkt am VCO. Dabei besteht die Aufgabe der Spannung $u_{SET}$ in der groben Frequenzselektion, d.h. der groben Voreinstellung auf eine gewünschte Zielfrequenz, und der Regelspannung $u_{PLL}$ in dem Ausgleich der verbleibenden Phasen- bzw. Frequenzdifferenzen.

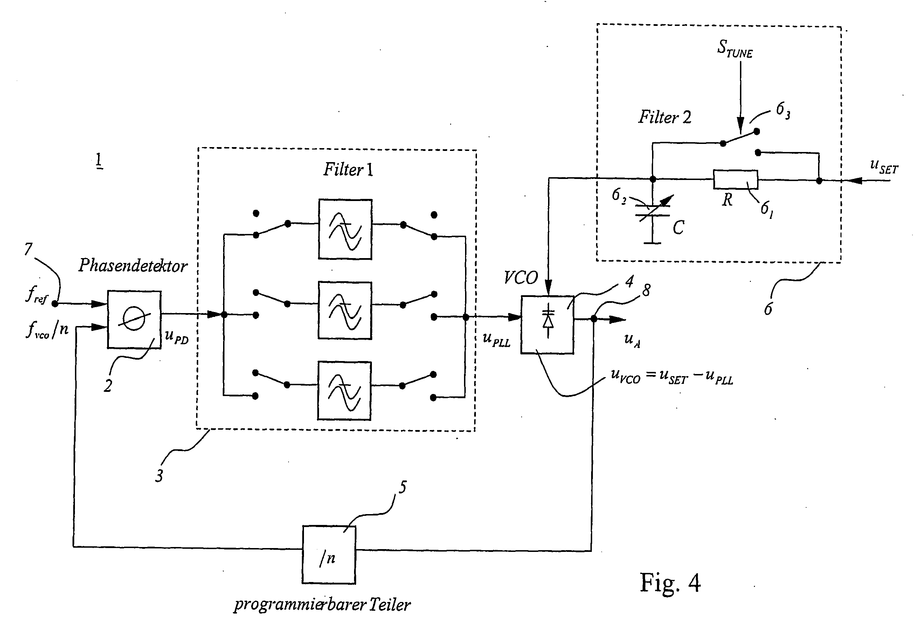

Der erfindungsgemäße PLL-Synthesizer, dessen Ausführungsbeispiel in Fig. 4 gezeigt ist, besteht wie beim Stand der Technik aus einem Phasendetektor 2, einem ersten Filter 3 und einem geregelten Oszillator (VCO) 4, wobei eine Regelspannung $u_{PLL}$ einem ersten Eingang und eine zweite Spannung $u_{SET}$ zur Frequenzselektion einem zweiten Eingang des Oszillators 4 zugeführt wird. Die Filterung der Spannung $u_{SET}$ zur groben Frequenzselektion erfolgt mittels eines Filters 6, das durch einen R-C-Tiefpass, bestehend aus einem Widerstand $6_1$ und einer Kapazität $6_2$, realisiert ist. Ein Schalterelement $6_3$, das den Widerstand $6_1$ überbrückt, erlaubt eine schnelle Vorladung der Kapazität $6_2$. Die Kapazität $6_2$ kann vorteilhaft einstellbar sein oder aus zwei Teilkapazitäten bestehen, wobei dann eine dieser Teilkapazitäten zuschaltbar ist.

Im Gegensatz zum Stand der Technik gemäß Fig. 3 erfolgt die Zuleitung der Spannung $u_{SET}$ zur groben Frequenzselektion nicht innerhalb des Regelkreises, sondern wird dem geregelten Oszillator (VCO) 4 an einem zweiten Eingang zugeführt. Damit entfällt ein zweites Filter, da die Spannung $u_{SET}$ zur groben Frequenzselektion, die von einem Digital/Analog-Wandler (nicht gezeigt) kommend, außerhalb des Regelkreises mit dem Tiefpass 6 gefiltert wird, direkt dem Oszillator (VCO) 4 an dessen zweiten Eingang zugeführt wird. Die inhärente Zeitkonstante des Filters 6 kann durch Einsatz des Schalterelements $6_3$ überbrückt werden und ermöglicht damit gegenüber dem Stand der Technik gemäß Fig. 3 schnellere Frequenzwechselzeiten.

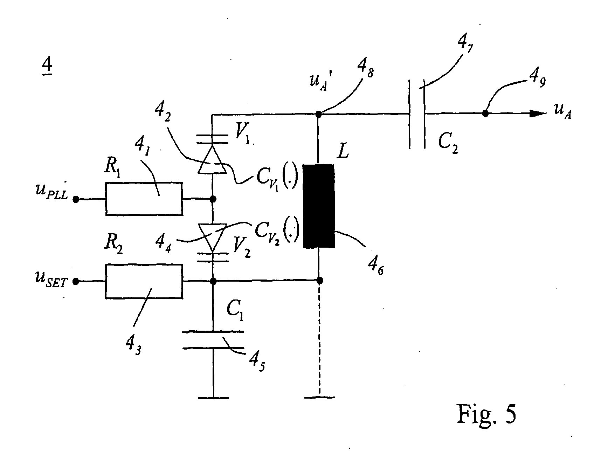

Ein Ausführungsbeispiel des Resonators eines im Rahmen der Erfindung einsetzbaren spannungsgeregelten Oszillators ist in Fig. 5 dargestellt. Fig.5 zeigt nur einen Teil eines VCO's, nämlich den Resonator. Wird ein aktives Bauteil (Transistor) ergänzt, erst dann handelt es sich um einen kompletten VCO. Der Oszillator 4 besteht aus zwei Varaktor-Dioden $4_2$ und $4_4$, die mit einer festen Induktivität $4_6$ einen Schwingkreis bilden, einer Ausgangskapazität $4_7$, die einen Kurzschluß für hochfrequente Spannungen und Ströme bildet sowie eventuelle konstante bzw. niederfrequente Strom- bzw. Spannungsanteile abblockt, und einer Kapazität $4_5$, die für hochfrequente Signale einen Kurzschluß nach Masse bildet.

Insbesondere ist dabei ein erster Widerstand $4_1$ mit einem zweiten Anschluß mit einem ersten Anschluß einer ersten Varaktor-Diode $4_2$, und ein zweiter Widerstand $4_3$ mit einem ersten Anschluß einer zweiten Varaktor-Diode $4_4$ verbunden. Die zweite Diode $4_4$ ist dabei mit einem zweiten Anschluß mit dem zweiten Anschluß des Widerstandes $4_1$ und dem ersten Anschluß der ersten Diode $4_2$ verbunden. Der zweite Widerstand $4_3$ ist über die Kapazität $4_5$ mit Masse verbunden. Ein ersten Anschluß der Induktivität $4_6$ ist mit einem zweiten Anschluß des zweiten Widerstandes $4_3$, einem ersten Anschluß der Kapazität $4_5$, und dem ersten Anschluß der zweiten Diode $4_4$ verbunden und ein zweiten Anschluß der Induktivität $4_6$ ist mit einem zweiten Anschluß der ersten Diode $4_2$ verbunden.

Die Induktivität bildet mit den Dioden $4_2$ und $4_4$ eine Parallelschaltung. Die Durchlaßrichtung der zweiten Diode $4_4$ verläuft dabei von dem zweiten Anschluß des ersten Widerstandes $4_1$ zu dem zweiten Anschluß des zweiten Widerstandes $4_3$. Die Durchlaßrichtung der ersten Diode $4_2$ verläuft von dem zweiten Anschluß des Widerstandes $4_1$ zu dem zweiten Anschluß der Induktivität $4_6$. Die Induktivität $4_6$ und die erste Diode $4_2$ sind jeweils mit einem zweiten Anschluß am Punkt $4_8$ über eine Kapazität $4_7$ mit dem Ausgang $4_9$ des Resonators verbunden. Der erster Anschluß der Induktivität $4_6$, der mit dem zweiten Anschluß des zweiten Widerstands $4_3$ und dem ersten Anschluß der zweiten Diode $4_4$ verbunden ist, kann auch direkt mit Masse verbunden werden.

Die Hauptelemente des Schwingkreises werden aus den spannungsgesteuerten Dioden $4_2$ und $4_4$ sowie der Induktivität $4_6$ gebildet, wobei die Spannungen $u_{PLL}$ bzw. $u_{SET}$ über einen ersten Anschluß der Widerstände $4_1$ bzw. $4_3$ eingekoppelt werden. Die Kapazität $4_5$ bildet dabei eine Gleichspannungstrennung gegen Masse und eine Durchverbindung für hochfrequente Schwingungen. Die Ausgangskapazität $4_7$ koppelt im Gegensatz dazu Gleichspannungs- und niederfrequente Schwingungs- oder Signalanteile zum Ausgang $4_9$ hin von der Ausgangsspannung $u_A$ ab.

Die Spannungen $u_{PLL}$ und $u_{SET}$ stellen die Varaktor-Dioden $4_2$ und $4_4$ je nach Vorgabe durch den Phasendetektor und die Frequenzselektion auf einen Arbeitspunkt ein. Die Spannungsdifferenz $\Delta u_1 = u_{PLL} - u_A$' bestimmt dabei aufgrund der Kennlinie $C_{v_1}(\Delta u_1)$ der ersten Diode $4_2$ eine erste Kapazität und die Spannungsdifferenz $\Delta u_2 = u_{PLL} - u_{SET}$ legt aufgrund der Kennlinie $C_{v_2}(\Delta u_2)$ der zweiten Diode $4_4$ eine zweite Kapazität fest. Die erste Spannungsdifferenz ist dabei gleich der zweiten Spannungsdifferenz, da die Induktivität $4_6$ für konstante Spannung $u_{SET}$ eine Durchverbindung darstellt, d.h. $u_A$'$=u_{SET}$ und somit $\Delta u_2 = \Delta u_1$ gilt. Bei dieser VCO-Schaltung kann anstatt der Kapazität $4_5$ auch eine direkte Erdung erfolgen.

Die Gesamtkapazität der Varaktordioden $4_2$ und $4_4$ kann dabei nach Voreinstellung der Spannung mit folgender Formel berechnet werden:

$$( 7 ) \qquad C_{ges}(\Delta u_1, \Delta u_2) = \frac{C_{v_1}(\Delta u_1) \ C_{v_2}(\Delta u_2)}{C_{v_1}(\Delta u_1) + C_{v_2}(\Delta u_2)}$$

wobei $\Delta u_1 = u_{PLL} - u_A$' den Spannungsabfall über die erste Diode $4_2$ und $\Delta u_2 = {}^u_{PLL} - u_{SET}$ den Spannungsabfall über die zweite Diode $4_4$ darstellt. In Gleichung ( 7 ) repräsentiert $C_{v_1}(.)$ eine Kennlinie der ersten Diode $4_2$ und $C_{v_2}(.)$ eine Kennlinie der zweiten Diode $4_4$. Die Spannungen $u_{SET}$, $u_{PLL}$ und $u_A$' sind dabei Spannungen zur groben Frequenzselektion ($u_{SET}$) und zur Feinjustierung ($u_{PLL}$) bzw. Ausregelung des Arbeitspunktes sowie eine Spannung ($u_A$') am Punkt $4_8$ der VCO-Schaltung.

Im folgenden werden weitere Vorteile der erfindungsgemäßen Ausführung nach Fig. 4 beschrieben.

Durch den Einsatz einer Charge-Pump (nicht dargestellt) kann auf aktive Filter bei der erfindungsgemäßen Realisierung vollkommen verzichtet werden. Rauscheinträge kommen somit nur noch durch Rausch- oder Störfrequenzanteile im Oszillatorreferenzsignal und passive Bauelemente zustande.

Die Auslegung des Filters 3 erfolgt als stufenförmiger Tiefpass. Es ergibt sich in Zusammenwirkung mit den Eigenschaften der restlichen Schleifenglieder ein Tiefpassverhalten. Mit Hilfe eines automatisierten Auslegeverfahrens können geeignete Bauteilewerte für eine R-C-Schaltung bestimmt werden.

Die Regelspannung $u_{PLL}$ hat z. B. einen Varianzbereich von $\pm 1,5$ V, wodurch sich die Ausgangsschwingungsform entsprechend der Bauteilekennlinien minimal verändert.


**Patentansprüche**

1. PLL-Synthesizer (1) mit einem Phasendetektor (2), zumindest einem umschaltbaren Filter (3), einem durch eine Regelspannung ($u_{PLL}$) geregelten Oszillator (4) und einem Teiler (5),
   wobei der geregelte Oszillator (4) zwei Eingänge besitzt,
   wobei an einem ersten Eingang die Regelspannung ($u_{PLL}$) und an einem zweiten Eingang eine Selektionsspannung ($u_{SET}$) zur groben Frequenzeinstellung eingekoppelt sind und wobei beide Spannungen die Frequenz des Oszillators (4) festlegen,
   wobei der geregelte Oszillator (4) zwei spannungsgesteuerte Varaktor-Dioden ($4_2$, $4_4$), eine Induktivität ($4_6$) und zwei fest vorgegebene Kapazitäten ($4_5$) und ($4_7$) aufweist, und
   wobei ein erster Widerstand ($4_1$) mit einem zweiten Anschluss mit einem ersten Anschluss einer ersten Varaktor-Diode ($4_2$) und ein zweiter Widerstand ($4_3$) mit einem ersten Anschluss einer zweiten Varaktor-Diode ($4_4$) verbunden ist, und die Induktivität ($4_6$) mit den Varaktor-Dioden ($4_2$, $4_4$) eine Parallelschaltung bildet,
   **dadurch gekennzeichnet,**
   **dass** die Durchlassrichtung der zweiten Varaktor-Diode ($4_4$) von dem zweiten Anschluss des ersten Widerstandes ($4_1$) zu einem zweiten Anschluss des zweiten Widerstandes ($4_3$) verläuft, und die Durchlassrichtung der ersten Varaktor-Diode ($4_2$) von dem zweiten Anschluss des ersten Widerstandes ($4_1$) zu einem zweiten Anschluss der Induktivität ($4_6$) verläuft.

2. PLL-Synthesizer gemäß Anspruch 1,
   **dadurch gekennzeichnet,**
   **dass** die Selektionsspannung ($u_{SET}$) zur Frequenzselektion mit einem R-C-Tiefpass (6) geglättet ist.

3. PLL-Synthesizer gemäß Anspruch 2,
   **dadurch gekennzeichnet,**

**dass** eine Kapazität ($6_2$) des Tiefpasses einstellbar ist und einen Widerstand ($6_1$) sowie einen Anschluss eines Schaltelements ($6_3$) nach Masse verbindet, wobei das Schaltelement ($6_3$) den Widerstand ($6_1$) zur Vorladung der Kapazität ($6_2$) überbrückt.

4. PLL-Synthesizer gemäß Anspruch 3,
   **dadurch gekennzeichnet,**
   **dass** die Kapazität ($6_2$) aus zwei Kondensatoren besteht.

5. PLL-Synthesizer gemäß Anspruch 4,
   **dadurch gekennzeichnet,**
   **dass** einer der beiden Kondensatoren zuschaltbar ausgestaltet ist.

6. PLL-Synthesizer nach einem der Ansprüche 1 bis 5,
   **dadurch gekennzeichnet,**
   **dass** die Induktivität ($4_6$) und die erste Diode ($4_2$) jeweils über eine fest vorgegebene Kapazität ($4_7$) mit dem Ausgang ($4_9$) des Oszillators (4) verbunden sind.

7. PLL-Synthesizer gemäß einem der Ansprüche 1 bis 6,
   **dadurch gekennzeichnet,**
   **dass** der zweite Widerstand ($4_3$) über eine fest vorgegebene Kapazität ($4_5$) mit Masse verbunden ist.

8. PLL-Synthesizer gemäß einem der Ansprüche 1 bis 7,
   **dadurch gekennzeichnet,**
   **dass** ein erster Anschluss der Induktivität ($4_6$), der mit dem zweiten Anschluss des zweiten Widerstandes ($4_3$) und dem ersten Anschluss der zweiten Diode ($4_4$) verbunden ist, direkt mit Masse verbunden ist.

9. PLL-Synthesizer gemäß einem der Ansprüche 1 bis 8,
   **dadurch gekennzeichnet,**
   **dass** eine Gesamtkapazität der Varaktor-Dioden ($4_2$) und ($4_4$) sich aus folgender Formel ergibt:

$$C_{ges}\left(\Delta u_1, \Delta u_2\right) = \frac{C_{V_1}\left(\Delta u_1\right) \bullet C_{V_2}\left(\Delta u_2\right)}{C_{V_1}\left(\Delta u_1\right) + C_{V_2}\left(\Delta u_2\right)}$$

wobei $\Delta u_1 = u_{PLL} - u_A'$ den Spannungsabfall über die erste Varaktor-Diode ($4_2$) und $\Delta u_2 = u_{PLL} - u_{SET}$ den Spannungsabfall über die zweite Varaktor-Diode ($4_4$) bedeuten und $C_{v_1}(.)$ eine Kennlinie einer ersten Varaktor-Diode ($4_2$) und $C_{v_2}(.)$ eine Kennlinie einer zweiten Varaktor-Diode ($4_4$) repräsentieren und $u_{SET}$ die Selektionsspannung, $u_{PLL}$ die Regelspannung und $u_A'$ eine Spannung am Punkt ($4_8$) des Oszillators (4) bedeuten.

**Claims**

1. PLL synthesiser (1) with a phase detector (2), at least one switchable filter (3), an oscillator (4) controlled by a control voltage ($u_{PLL}$) and a divider (5),
   wherein the controlled oscillator (4) has two inputs,
   wherein the control voltage ($u_{PLL}$) is coupled to a first input, and a selection voltage ($u_{SET}$) for coarse frequency adjustment is coupled to a second input, and wherein both voltages establish the frequency of the oscillator (4),
   wherein the controlled oscillator (4) provides two voltage-controlled varactor diodes ($4_2$, $4_4$), one inductance ($4_6$) and two fixed-specification capacitors ($4_5$) and ($4_7$), and
   wherein a first resistor ($4_1$) is connected by a second connection to a first connection of a first varactor diode ($4_2$), and a second resistor ($4_3$) is connected to a first connection of a second varactor diode ($4_4$), and the inductance ($4_6$) forms a parallel circuit with the varactor diodes ($4_2$, $4_4$),
   **characterised in that**
   the throughput direction of the second varactor diode ($4_4$) extends from the second connection of the first resistor ($4_1$) to a second connection of the second resistor ($4_3$), and the throughput direction of the first varactor diode ($4_2$) extends from the second connection of the first resistor ($4_1$) to a second connection of the inductance ($4_6$).

**2.** PLL synthesiser according to claim 1,
**characterised in that**
the selection voltage ($u_{SET}$) for frequency selection is smoothed with an R-C low-pass filter (6).

**3.** PLL synthesiser according to claim 2,
**characterised in that**
a capacitor ($6_2$) of the low-pass filter is adjustable and connects a resistor ($6_1$) and a connection of a switching element ($6_3$) to earth, wherein the switching element ($6_3$) bridges the resistor ($6_1$) in order to pre-charge the capacitor ($6_2$).

**4.** PLL synthesiser according to claim 3,
**characterised in that**
the capacitor ($6_2$) consists of two condensers.

**5.** PLL synthesiser according to claim 4,
**characterised in that**
one of the two condensers is designed to be switchable into the system.

**6.** PLL synthesiser according to any one of claims 1 to 5,
**characterised in that**
the inductance ($4_6$) and the first diode ($4_2$) are each connected via a fixed-specification capacitor ($4_7$) to the output ($4_9$) of the oscillator (4).

**7.** PLL synthesiser according to any one of claims 1 to 6,
**characterised in that**
the second resistor ($4_3$) is connected to earth via a fixed-specification capacitor ($4_5$).

**8.** PLL synthesiser according to any one of claims 1 to 7,
**characterised in that**
a first connection of the inductance ($4_6$), which is connected to the second connection of the second resistor ($4_3$) and to the first connection of the second diode ($4_4$), is connected directly to earth.

**9.** PLL synthesiser according to any one of claims 1 to 8,
**characterised in that**
an overall capacitance [$C_{ges}$] of the varactor diodes ($4_2$) and ($4_4$) is obtained from the following formula:

$$C_{ges}(\Delta u_1, \Delta u_2) = \frac{C_{v_1}(\Delta u_1) \bullet C_{v_2}(\Delta u_2)}{C_{v_1}(\Delta u_1) + C_{v_2}(\Delta u_2)}$$

wherein $\Delta u_1 = u_{PLL} - u_A'$ denotes the voltage drop across the first varactor diode ($4_2$), $\Delta u_2 = u_{PLL} - u_{SET}$ denotes the voltage drop across the second varactor diode ($4_4$), $C_{v_1}(.)$ denotes a characteristic of a first varactor diode ($4_2$), $C_{v_2}(.)$ denotes a characteristic of a second varactor diode ($4_4$), $u_{SET}$ denotes the selection voltage, $u_{PLL}$ denotes the control voltage and $u_A'$ denotes a voltage at the point ($4_8$) of the oscillator (4).

**Revendications**

**1.** Synthétiseur PLL (1) avec un détecteur de phases (2), au moins un filtre commutable (3), un oscillateur (4) réglé par une tension de réglage ($u_{PLL}$) et un diviseur (5),
l'oscillateur (4) réglé possédant deux entrées,
la tension de réglage ($u_{PLL}$) étant couplée à une première entrée et une tension de sélection ($u_{SET}$) étant couplée à une seconde entrée pour le réglage global de la fréquence et les deux tensions définissant la fréquence de l'oscillateur (4),
l'oscillateur (4) réglé présentant deux diodes varactor ($4_2$, $4_4$) commandées en tension, une inductance ($4_6$) et deux capacités ($4_5$) et ($4_7$) définies de manière fixe, et une première résistance ($4_1$) avec un second branchement étant reliée à un premier branchement d'une première diode varactor ($4_2$) et une seconde résistance ($4_3$) étant reliée à un premier branchement d'une seconde diode varactor ($4_4$), et l'inductance ($4_6$) formant avec les diodes varactor ($4_2$, $4_4$) un circuit parallèle,
**caractérisé en ce que**
le sens de conduction de la seconde diode varactor ($4_4$) s'étend depuis le second branchement de la première résistance ($4_1$) vers un second branchement de la seconde résistance ($4_3$), et **en ce que** le sens de conduction de la première diode varactor ($4_2$) s'étend depuis le second branchement de la première résistance ($4_1$) vers un second branchement de l'inductance ($4_6$).

2. Synthétiseur PLL selon la revendication 1,
**caractérisé en ce que**
la tension de sélection ($u_{SET}$) pour la sélection de la fréquence est lissée avec un filtre passe-bas RC (6).

3. Synthétiseur PLL selon la revendication 2,
**caractérisé en ce que**
une capacité ($6_2$) du filtre passe-bas peut être réglée et relie à la masse une résistance ($6_1$), ainsi qu'un branchement d'un élément de commutation ($6_3$), l'élément de commutation ($6_3$) court-circuitant la résistance ($6_1$) pour précharger la capacité ($6_2$).

4. Synthétiseur PLL selon la revendication 3,
**caractérisé en ce que**
la capacité ($6_2$) est composée de deux condensateurs.

5. Synthétiseur PLL selon la revendication 4,
**caractérisé en ce que**
l'un des deux condensateurs est configuré de manière à pouvoir être activé.

6. Synthétiseur PLL selon l'une quelconque des revendications 1 à 5,
**caractérisé en ce que**
l'inductance ($4_6$) et la première diode ($4_2$) sont respectivement reliées à la sortie ($4_9$) de l'oscillateur (4) par le biais d'une capacité ($4_7$) fixe de valeur prédéterminée.

7. Synthétiseur PLL selon l'une quelconque des revendications 1 à 6,
**caractérisé en ce que**
la seconde résistance ($4_3$) est reliée à la masse par le biais d'une capacité ($4_5$) fixe de valeur prédéterminée.

8. Synthétiseur PLL selon l'une quelconque des revendications 1 à 7,
**caractérisé en ce que**
un premier branchement de l'inductance ($4_6$), qui est relié au second branchement de la seconde résistance ($4_3$) et au premier branchement de la seconde diode ($4_4$), est relié directement à la masse.

9. Synthétiseur PLL selon l'une quelconque des revendications 1 à 8,
**caractérisé en ce que**
une capacité totale des diodes varactor ($4_2$) et ($4_4$) découle de la formule suivante :

$$C_{ges}\left(\Delta u_1, \Delta u_2\right) = \frac{C_{V_1}\left(\Delta u_1\right) \bullet C_{V_2}\left(\Delta u_2\right)}{C_{V_1}\left(\Delta u_1\right) + C_{V_2}\left(\Delta u_2\right)}$$

$\Delta u_1 = u_{PLL} - u_A$' désignant la chute de tension sur la première diode varactor ($4_2$) et $\Delta u_2 = u_{PLL} - u_{SET}$ désignant la chute de tension sur la seconde diode varactor ($4_4$) et $C_{V_1}(.)$ représentant une courbe caractéristique d'une première diode varactor ($4_2$) et $C_{V_2}(.)$ représentant une courbe caractéristique d'une seconde diode varactor ($4_4$), et $u_{SET}$ désignant la tension de sélection, $u_{PLL}$ la tension de réglage et $u_A$' une tension au point ($4_8$) de l'oscillateur (4).

$\theta_i$

$\theta_o'$

$G(s)$

$K_d$

$F(s)$

$\dfrac{K_o}{s}$

$\theta_o$

$H(s)$

Fig. 1

Stand der Technik

Fig. 2

Stand der Technik

Fig. 3

Stand der Technik

EP 1 847 020 B1

Fig. 4

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10160627 A1

- US 4205272 A